# EUROPEAN PATENT SPECIFICATION

(11) **EP 3 971 111 B1**
(45) Date of publication and mention of the grant of the patent: **23.04.2025**
(21) Application number: 20805018.7
(22) Date of filing: 10.03.2020
(51) Int. Cl.: G05D 1/00, H01L 21/677

(54) **TRANSPORT SYSTEM AND TRANSPORT CONTROL METHOD**
TRANSPORTSYSTEM UND TRANSPORTSTEUERUNGSVERFAHREN
SYSTÈME DE TRANSPORT ET PROCÉDÉ DE COMMANDE DE TRANSPORT

(30) Priority: 14.05.2019 JP 2019091260
(43) Date of publication of application: 23.03.2022
(73) Proprietor: Murata Machinery, Ltd., Kyoto-shi, Kyoto 601-8326 (JP)
(72) Inventor: TAKAHARA, Masayuki, Inuyama-shi, Aichi 484-8502 (JP)
(74) Representative: Weickmann & Weickmann PartmbB
(86) International application number: PCT/JP2020/010215
(87) International publication number: WO 2020/230427

(56) References cited:
- EP-A1- 2 343 616
- WO-A1-2015/186440
- WO-A1-2017/098813
- JP-A- 2003 208 222
- JP-A- 2010 064 806
- JP-A- 2018 125 042
- JP-A- H11 143 538

## Description

### Technical Field

The present invention relates to a transport system and a transport control method.

### Background Art

In a semiconductor device manufacturing factory or the like, articles accommodating, for example, semiconductor wafers or reticles are transported by a transport system. A transport system includes, for example, transport vehicles that travel on a track and a controller that controls the transport vehicles. The transport vehicles transmit information such as their current location to the controller by means of communication such as wireless communication. The controller determines a transport vehicle to execute transportation on the basis of the position of the transport vehicle, and assigns a transport instruction to cause the determined transport vehicle to pick up an article at a pickup port, transport the article picked up at the pickup port to an unloading port, and unload the article (for example, see Japanese Patent No. JP 6176399 B2 or corresponding publication US 2017/0144681 A1).

A transport system according to the preamble part of claim 1 appears to be known from JP 2018 125042 A. The prior art system and method aims to avoid collisions of transport vehicles at route merging points by a dedicated merging point passing control. EP 2 343 616 A1 appears to essentially start from a system having a similar merging point passing control, but strives to improve this control such that the conveyance efficiency of the system is improved.

### Summary of Invention

### Technical Problem

In the above transport system, in some cases, a part of the route from the current position of the transport vehicle to the pickup port or a part of the route from the pickup port to the unloading port may be closed for maintenance and other reasons. Also, another transport vehicle may be at a stop on the above route in some cases for reasons such as congestion or failure. In such a case, the transport vehicle is unable to travel on the closed route or on the route on which another transport vehicle is at a stop. In the transport system mentioned above, a no-traveling section is set in the section in which a traveling route cannot be secured, and a transport instruction is suspended and not assigned to any transport vehicle until this no-traveling section is lifted. Therefore, for example, if a no-traveling section is set in a part of the route from the load port of a processing apparatus serving as the pickup port to the unloading port, the transport vehicle will not perform pickup at the load port of the processing apparatus. As a result, the article is left to remain at the load port of the processing apparatus, and the processing apparatus becomes unable to accept a new article, resulting in a reduction in the utilization rate of the processing apparatus.

An object of the present invention is to provide a transport system and a transport control method capable of avoiding an article from being left to remain at a pickup port.

### Means for Solving Problem

For achieving this object, the present invention provides a transport system as is defined in claim 1 and a transport control method as is defined in claim 10.

Preferred embodiment of the transport system are defined in dependent claims 2 to 9.

### Advantageous Effects of the Invention

According to the transport system and the transport control method defined in claims 1 and 10, as a result, an article can be quickly transported out from the pickup port, and another article can be placed at the pickup port from which the article has been transported out. In the case where a traveling route to the unloading port can be secured before the transport vehicle approaches or reaches the specified point, the second special transport instruction (herein synonymously also denoted as "second transport instruction") causes the transport vehicle to travel straight to the unloading port and unloads the article at the unloading port. As a result, the amount of time taken to transport an article is reduced and the efficiency of transporting articles can be improved compared to the case where a normal transport instruction (herein synonymously also denoted as "transport instruction") is assigned to a transport vehicle when the entire traveling route for the transport vehicle has been secured.

In the configuration in which the first special transport instruction (herin synonymously also denoted as "first transport instruction") is an instruction to cause the transport vehicle to travel to the specified point and hold but not unload the article, transport of an article can be performed quickly in the case where a traveling route from the specified point to the unloading port can be secured, compared to a configuration in which a transport vehicle having traveled to the specified point unloads the article once at a storage or the like. In the configuration in which the specified point is set immediately before a branching part or a merging part on the track, it is possible at the branching part to select a traveling route that can be traveled after the specified point, and it is possible at the merging part to secure a passage of another transport vehicle through the merging part. In the case where the specified point is set immediately before the branching part, the branching part is a branching part closest to the pickup port, it is possible to easily change to another traveling route by means of the branching part while transporting an article from the pickup port.

In the configuration in which the controller determines whether or not to assign the first special transport instruction and the second special transport instruction, according to the type of at least one of the pickup port and the unloading port, the first special transport instruction causes an article to be transported out quickly from the pickup port from which articles are required to be transported out promptly, and therefore, the processing load on the controller can be reduced. In the configuration in which the controller assigns the first special transport instruction and the second special transport instruction to the transport vehicle in the case where the pickup port is a load port of a processing apparatus, an article is transported out quickly from the load port of the processing apparatus, and therefore, a new article can be placed on the load port of the processing apparatus, and the utilization rate of the processing apparatus can be improved. In the configuration in which the controller assigns the first special transport instruction and the second special transport instruction to the transport vehicle in the case where the pickup port is a load port of a stocker, an article is transported out quickly from the load port of the stocker, and therefore, a new article can be placed on the load port of the stocker, and the utilization rate of the stocker can be improved.

In the configuration in which the controller assigns the first special transport instruction and the second special transport instruction in the case where the pickup port is a buffer, on which an article can be placed, and the unloading port is a load port of a processing apparatus, and the controller does not assign the first transport special instruction and the second special transport instruction in the case where the pickup port is the buffer and the unloading port is other than a load port of a processing apparatus, an article can be transported to the load port of the processing apparatus in a short period of time. In the configuration in which the controller is a transport controller that controls a plurality of the transport vehicles, or an in-vehicle controller fitted in the transport vehicle, the transport vehicles can be controlled efficiently.

### Brief Description of the Drawings

Fig. 1 is a diagram showing an example of a transport system and a controller according to a first embodiment.
Fig. 2 is a diagram showing an example of a functional block configuration of the controller.
Fig. 3 is a diagram showing an example of a configuration of a transport vehicle.
Fig. 4 is a diagram showing an example of an operation flow of the controller according to the first embodiment.
Fig. 5 is an explanatory diagram showing an example of an operation of the transport vehicle in the first embodiment.
Fig. 6 is an explanatory diagram, which follows Fig. 5, showing an example of an operation of the transport vehicle.
Fig. 7 is an explanatory diagram, which follows Fig. 6, showing an example of an operation of the transport vehicle.
Fig. 8 is a diagram showing an example of an operation flow of a controller according to a second embodiment.
Fig. 9 is an explanatory diagram showing an example of an operation of a transport vehicle in the second embodiment.
Fig. 10 is an explanatory diagram, which follows Fig. 9, showing another example of an operation of the transport vehicle.
Fig. 11 is an explanatory diagram showing another example of the operation of the transport vehicle.
Fig. 12 is a diagram showing an example of a functional block configuration of a controller according to a third embodiment.
Fig. 13 is a diagram showing another example of an operation flow of the controller according to the third embodiment.
Fig. 14 is a table showing the relationship between the types of pickup ports and unloading ports, and the types of transport instructions to be assigned.
Fig. 15 is an explanatory diagram showing another example of an operation of a transport vehicle in a fourth embodiment.

### Description of Embodiments

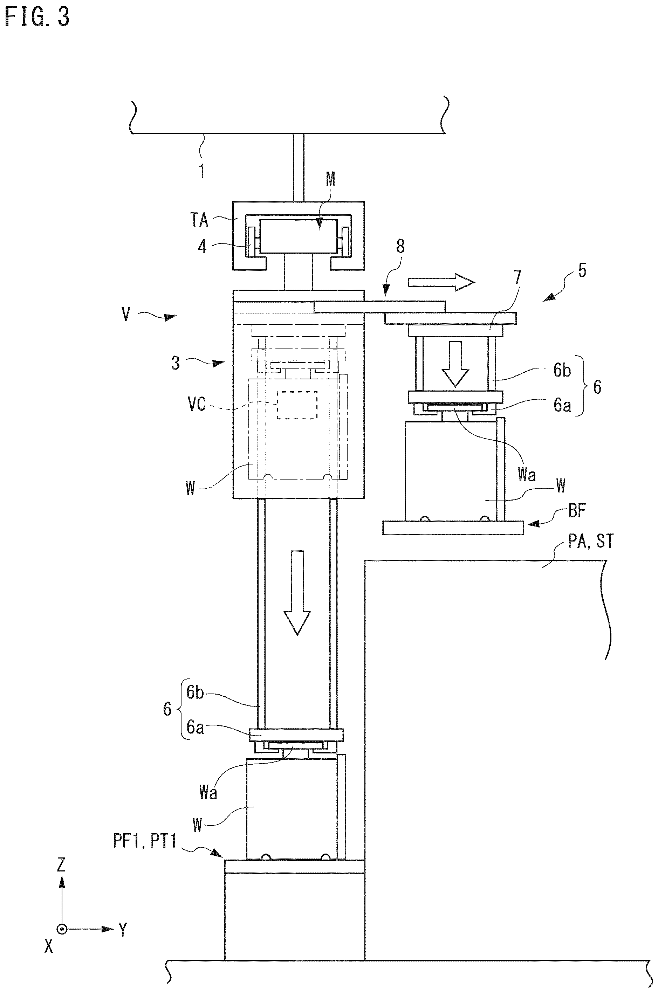

The following describes embodiments of the present invention with reference to the drawings. However, the present invention is not limited to the embodiments. In the drawings, scale is changed as necessary to illustrate the embodiment, such as by enlarging or by emphasizing a part. In Fig. 3, an XYZ coordinate system is used to describe directions in the figure. In this XYZ coordinate system, a plane that is parallel to a horizontal plane is defined as an XY plane. In this XY plane, a traveling direction of a transport vehicle V is denoted as an X direction, and a direction orthogonal to the X direction is denoted as a Y direction. A direction perpendicular to the XY plane is denoted as a Z direction. For each of the X direction, the Y direction, and the Z direction, description is made with a definition in which a direction indicated by an arrow is the positive (+) direction and a direction opposite to the direction indicated by the arrow is the negative (-) direction.

### First Embodiment

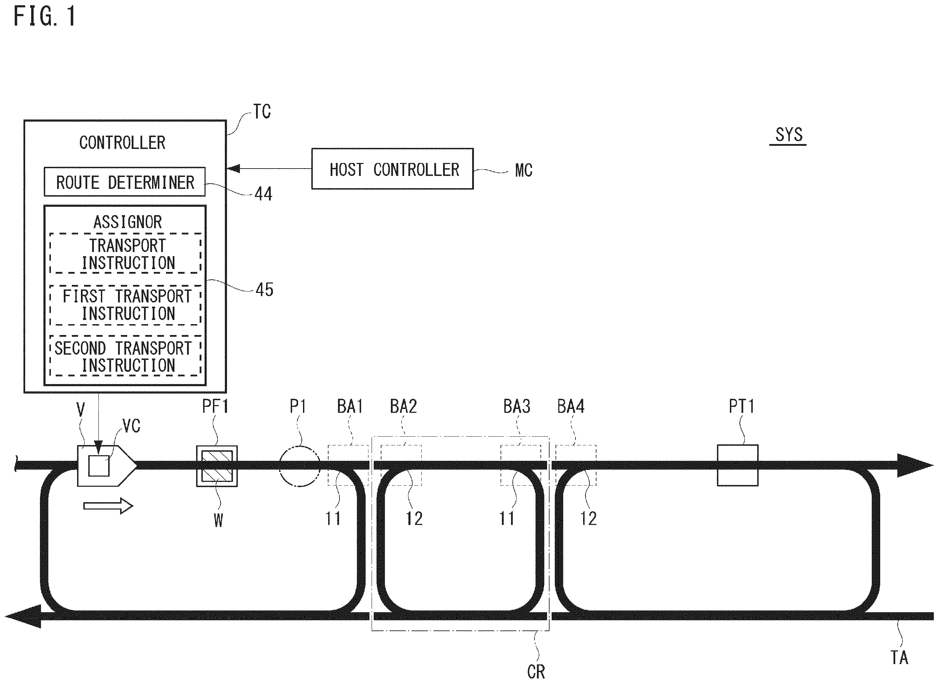

Fig. 1 is a diagram showing an example of a transport system and a controller according to a first embodiment. A transport system SYS according to the present embodiment is a system for transporting articles W by means of transport vehicles V. The transport system SYS is installed in, for example, a semiconductor manufacturing factory. The article W is, for example, a FOUP, a SMIF pod, a reticle pod, or the like capable of accommodating wafers, reticles, or the like. The transport system SYS includes, for example, a host controller MC, a controller TC, and a plurality of transport vehicles V. The controller TC is a transport controller that controls the plurality of transport vehicles V. In the present embodiment, one of the plurality of transport vehicles V is shown; however, the other transport vehicles V are similar thereto.

Each transport vehicle V travels along a predetermined track TA (route) and transports an article W. The track TA includes branching parts 11 and merging parts 12. Blocking areas BA1 to BA4 are set in the branching parts 11 and the merging parts 12. The passage of the transport vehicle V is restricted in the blocking areas BA1 to BA4. For example, when the transport vehicle V is to pass through the blocking areas BA1 to BA4, the transport vehicle V transmits a passage request for the blocking areas BA1 to BA4 to a blocking controller not shown in the drawings. The transport vehicle V will pass through the blocking areas BA1 to BA4 if a passage permission is received from the blocking controller; however, the transport vehicle V will stop immediately before each of the blocking areas BA1 to BA4 and not enter the blocking areas BA1 to BA4 if the passage permission is not obtained. The track TA can be set arbitrarily, and is installed suspended from a ceiling 1 (see Fig. 3) of a building, for example. Each transport vehicle V transports an article W according to a transport instruction assigned by the controller TC.

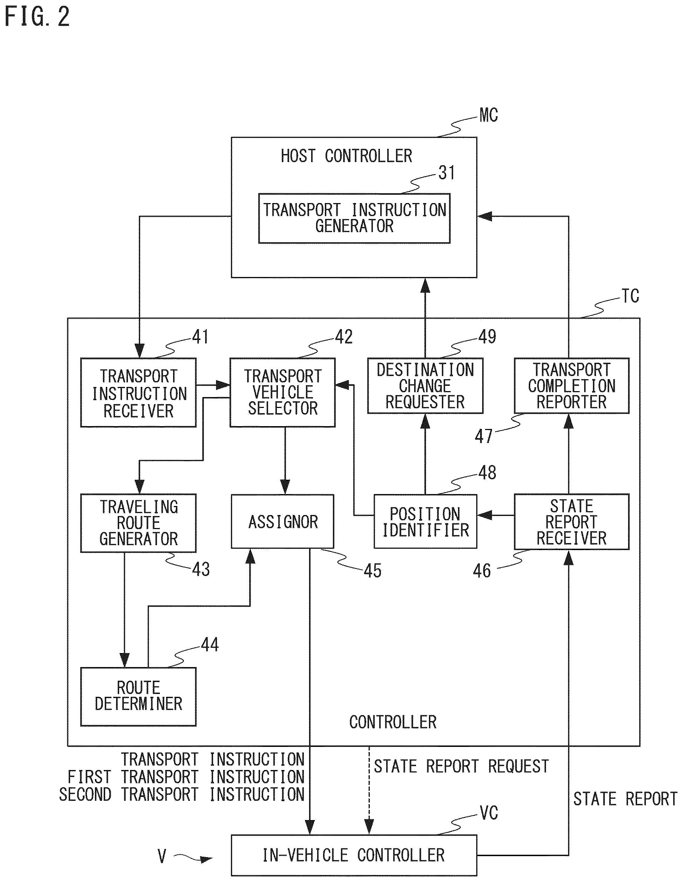

Fig. 2 is a diagram showing an example of a functional block configuration of the controller. In the present embodiment, the controller includes a host controller MC and a controller TC. The host controller MC includes, for example, a CPU, a main memory, a memory storage device, and a communication device, and performs tasks such as processing of various information, storing information, input and output of information, and communication (transmitting/receiving) of information. As the host controller MC, for example, a computer system is used.

The host controller MC instructs transportation of articles W in the transport system SYS. Each unit of the system including the controller TC transmits to the host controller MC information such as information related to the state of each pickup port PF1 and each unloading port PT1, or information related to the state of an instruction transmitted from the host controller MC to the controller TC. The host controller MC manages information such as position information of each article W, information related to the state of each pickup port or each unloading port (for example, the operating state of a device, the state of the occupancy of articles W), or information related to the state of an instruction transmitted from the host controller MC to the controller TC (for example, being executed, execution completed, execution failed).

The host controller MC includes a host transport instruction generator (transport instruction generator) 31. The host transport instruction generator 31 generates a host transport instruction to transport a predetermined article W from a pickup port PF1, which is the origin of the transportation, to an unloading port PT1, which is the destination of the transportation. The host controller MC transmits the host transport instruction generated by the host transport instruction generator 31 to the controller TC. The host transport instruction includes, for example pickup port information indicating the position (pickup port PF1) of the article W to be transported, unloading port information indicating the position (unloading port PT1) at which the article W to be transported is to be unloaded, and an instruction to transport the article W at the pickup port PF1 to the unloading port PT1. The controller TC assigns a transport instruction related to the transportation of the article W to a transport vehicle V, on the basis of the host transport instruction received from the host controller MC. That is to say, the controller TC assigns to one of transport vehicles V a transport instruction to pick up an article W at the pickup port PF1 and unload the article W at the unloading port PT1.

The controller TC controls the transport vehicles V. The controller TC transmits various instructions to the transport vehicles V to thereby control the transport vehicles V. The controller TC includes, for example, a transport instruction receiver 41, a transport vehicle selector 42, a traveling route generator 43, a route determiner 44, an assignor 45, a state report receiver 46, a transport completion reporter 47, a position identifier 48, and a destination change requester 49. The controller TC includes, for example, a CPU, a main memory, a memory storage device, and a communication device, and performs tasks such as processing of various information, storing information, input and output of information, and communication (transmitting/receiving) of information. As the controller TC, for example, a computer system is used. The controller TC stores information required for controlling each transport vehicle V (for example, route information, map information), and a control program in a storage device not shown in the drawings. The configuration of the controller TC is not limited to the configuration shown in Fig. 2, and may employ another configuration.

The transport instruction receiver 41 receives a host transport instruction transmitted from the host controller MC. As mentioned above, the host transport instruction transmitted from the host controller MC to the controller TC includes a pickup port PF1 (From: transport origin) of an article W and an unloading port PT1 (To: transport destination) of the article W.

The transport vehicle selector 42 selects a transport vehicle V to which the transport instruction is to be assigned. For example, the transport vehicle selector 42 selects empty vehicles (transport vehicles not currently transporting an article W) from the plurality of transport vehicles V, and selects, from the selected empty vehicles, a transport vehicle V that is to arrive at the pickup port PF1 earliest. The traveling route generator 43 generates a traveling route on the track TA for the transport vehicle V from the pickup port PF1 to the unloading port PT1 designated in the transport instruction (host transport instruction). For example, the traveling route generator 43 selects the shortest route from the route information stored in a memory storage device not shown in the drawings, and generates a traveling route for the transport vehicle V.

The route determiner 44 determines whether or not the traveling route can be secured on the traveling route generated by the traveling route generator 43. For example, the route determiner 44 detects whether or not a part of the traveling route is closed on the traveling route generated by the traveling route generator 43. For example, damage to the track TA, presence of a failed vehicle, maintenance, and so forth can cause closure of a part of a traveling route, and an operator or the like inputs or transmits such closure to the controller TC. The closure of a traveling route is called "route down", and is set for each route by, for example, an operator or the like. If closure is not detected, the route determiner 44 determines that the traveling route can be secured. If closure of a part of the traveling route is detected, the route determiner 44 determines that the traveling route cannot be secured.

The assignor 45 assigns one of a transport instruction (or normal transport instruction) , a first transport instruction (or first special transport instruction), and a second transport instruction or second special transport instruction) to a transport vehicle V selected by the transport vehicle selector 42, on the basis of the determination result of the route determiner 44. In the present embodiment, the assignor 45 assigns a transport instruction to a transport vehicle V to cause it to pick up an article W at the pickup port PF1, travel along the traveling route mentioned above, and unload the article W at the unloading port PT1, in the case where the traveling route for the transport vehicle V from the pickup port PF1 to the unloading port PT1 designated by the transport instruction can be secured on the track TA.

The controller TC generates a first transport instruction in the case where the traveling route for the transport vehicle V from the pickup port PF1 to the unloading port PT1 designated by the transport instruction cannot be secured on the track TA. The assignor 45 assigns the transport instruction to the transport vehicle V instead of the previous transport instruction. The first transport instruction may be generated by the assignor 45, or may be generated by a transport instruction generator (not shown in the drawings) that is included as a unit separate from the assignor 45 in the controller TC. The first transport instruction causes the transport vehicle V to pickup an article W at the pickup port PF1, travel to a specified point P1 on the downstream side of the pickup port PF1 in the traveling direction of the transport vehicle V, at which point the traveling route can be secured on the track TA, and hold but not unload the article **W.**

In the first transport instruction, the specified point P1 is set immediately before the branching part 11 or the merging part 12 on the track TA. The specified point P1 may be set, for example, by the traveling route generator 43 or by the assignor 45. In the present embodiment, the specified point P1 is set at the branching part 11 that is on the downstream side of the pickup port PF1 and is closest to the pickup port PF1. As a result of the specified point P1 being set immediately before the branching part 11 or the merging part 12, it is possible at the branching part 11 to select another traveling route that can be traveled after the specified point P1 has been reached, and it is possible to secure a passage for another transport vehicle V through the merging part 12. Since the transport vehicle V is moved from above the pickup port PF1, another transport vehicle V can unload an article W to the pickup port PF1.

The assignor 45 assigns a second transport instruction to the transport vehicle V in the case where the traveling route from the specified point P1 to the unloading port PT1 can be secured at the point in time at which the transport vehicle V has approached or reached the specified point P1 (or before it reaches the specified point P1). That is to say, the assignor 45 assigns the second transport instruction to the transport vehicle V when the closure of the traveling route is lifted at the point in time at which the transport vehicle V has approached or reached the specified point P1, such as when repair of the track TA has been completed, when a failed vehicle has been removed, or when maintenance has ended. The second transport instruction is an instruction that causes a transport vehicle V to travel from the specified point P1 to the unloading port PT1 and unload an article W to the unloading port PT1.

The state report receiver 46 receives a state report that is transmitted from an in-vehicle controller VC in response to a state report request transmitted from the controller TC. State reports transmitted from the in-vehicle controller VC to the controller TC include a position report reporting the position of a transport vehicle V, a pickup completion report reporting a transport vehicle V having completed pickup of an article W, and a transport completion report reporting a transport vehicle V having completed unloading of an article W, and further includes information such as traveling speed. The transport completion reporter 47 reports to the host controller MC that transportation of an article W to the unloading port PT1 has been completed.

The position identifier 48 identifies the position of a transport vehicle V on the track TA, on the basis of a position report transmitted from the transport vehicle V. The destination change requester 49 reports that the destination of the transport vehicle V having received the first transport instruction has been changed to the specified point P1, and requests the host controller MC to newly determine an unloading port for the article W, taking the specified point P1 as a reference. As described above, the assignor 45 assigns the second transport instruction to the transport vehicle V in the case where the traveling route can be secured at the point in time at which the transport vehicle V has approached or reached the specified point P1. However, if the traveling route from the specified point P1 to the unloading port PT1 cannot be secured, the second transport instruction cannot be assigned and the transport vehicle V will remain stopped at the specified point P1. In a case where the second transport instruction cannot be assigned, for example, the destination change requester 49 transmits a destination change request to the host controller MC in order to request a new unloading port for the article W.

The host controller MC determines a new unloading port for the article W on the basis of the request from the destination change requester 49, and transmits the determination content related to the new unloading port for the article W to the controller TC. Upon receiving the determination content related to the new unloading port for the article W, the controller TC generates, in the traveling route generator 43, a traveling route from the specified point P1 to the new unloading port. The assignor 45 assigns to the transport vehicle V a third transport instruction (or third special transport instruction; the terms "third transport instruction" and "third special transport instruction are used synonymously herein) to cause it to travel from the specified point P1 to the new unloading port, and unload the article W at the new unloading port.

A configuration of the transport vehicle V will be described. Fig. 3 is a diagram showing an example of the configuration of the transport vehicle V. The transport vehicle V is an overhead transport vehicle that, for example, travels in one direction (+X direction) along the track TA suspended from the ceiling 1 or the like of the building, picks up an article W at the pickup port PF1 arranged on the lower side of (directly below) the track TA or on the lower and lateral side (in the Y direction) of the track TA, and unloads the article W at the unloading port PT1 arranged on the lower side of the track TA or on the lower and lateral side of the track TA.

The transport vehicle V includes an in-vehicle controller VC. The in-vehicle controller VC controls various operations of the transport vehicle V (such as traveling, speed control (accelerating, decelerating, and stopping), operations related to execution of pickup, and operations related to execution of unloading). The in-vehicle controller VC controls the transport vehicle V according to instructions transmitted from the controller TC. The controller TC transmits to the transport vehicle V, for example, the transport instruction mentioned above, a move instruction described later, and so forth as instructions to control the transport vehicle V. The in-vehicle controller VC is a computer system that includes, for example, a CPU, a main memory, a memory storage device, and a communication device, and performs tasks such as processing of various information, storing information, input and output of information, and communication (transmitting/receiving) of information.

The in-vehicle controller VC manages state information that indicates the state of the transport vehicle V. The in-vehicle controller VC transmits the state information to the controller TC in a manner of responding to a state report request transmitted periodically from the controller TC. Communications related to the state report request and the state information (state report including state information) that are exchanged between the in-vehicle controller VC and the controller TC, are performed periodically at predetermined time intervals. The controller TC receives state information (state report including state information) from each transport vehicle V periodically, and thereby grasps and manages the latest state of the transport vehicles V under the management thereof and the latest state of various instructions transmitted to the transport vehicles V by the controller TC.

Examples of the state information of a transport vehicle V include information indicating the current location of a transport vehicle V (current location information), information on traveling (such as speed and stop state), information on whether or not an article W is held, and information on the state (status) of various instructions transmitted from (assigned by) the controller TC. Examples of the information on the state of various instructions in the state information include information indicating completion or failure (inexecutability) of assignment of various instructions, information indicating completion or failure of execution of various instructions (such as transport instruction and move instruction), and information indicating completion or failure of execution of operations or processes related to various instructions (such as traveling, pickup, unloading). By receiving the state information (state report including state information) transmitted periodically from the transport vehicles V, the controller TC grasps the state of the transport vehicles V and the execution state of instructions for the transport vehicles V, and manages and controls the transport vehicles V. The state information (state report including state information) transmitted from a transport vehicle V enables the controller TC to recognize the transport vehicle V approaching or reaching the specified point P1.

Each transport vehicle V includes a traveler M and a main body 3 as shown in Fig. 3. The traveler M includes wheels 4 and travels along the track TA (route) by means of a traveling driver not shown in the drawings. The main body 3 is provided in a state of being suspended below the traveler M. The main body 3 includes a transferer 5. The transferer 5 includes an article holder 6 that holds an article W, a lift driver 7 that raises or lowers the article holder 6, and a lateral extender 8 that moves the lift driver 7 in a direction lateral to (in the +Y direction or the -Y direction of) the track TA.

The article holder 6 is a chuck having claws 6a that can be advanced or retracted, and inserts the claws 6a under a flange Wa of the article W to thereby suspend and hold the article W. The article holder 6 is connected to suspenders 6b such as wires and belts. The lift driver 7 is, for example, a hoist, and raises or lowers the article holder 6 by feeding out or taking up the suspenders 6b. The lateral extender 8 causes a plurality of movable plates to slide, thereby causing the article holder 6 and the lift driver 7 to move between a position for being stored in the main body 3 and a position for being projected toward a lateral side of the track TA. Pickup and unloading of an article W performed by the transport vehicle V is performed using the article holder 6, or the lift driver 7 and the lateral extender 8 mentioned above. Operations of the article holder 6, the lift driver 7, and the lateral extender 8 are controlled by the in-vehicle controller VC.

When an article W is to be picked up at the pickup port PF1, the in-vehicle controller VC instructs the transport vehicle V to stop so as to align with the pickup port PF1 and causes the lift driver 7, or the lift driver 7 and the lateral extender 8 to operate and move the article holder 6 to a predetermined position, to thereby pick up the article W at the pickup port PF1. The pickup port PF1 can be arbitrarily set in the transport system SYS. Examples of the pickup port PF1 include a load port of a processing apparatus PA or a load port of a stocker ST, and an overhead buffer (hereunder, referred to as buffer) BF provided with a shelf, on which an article W can be placed, suspended from the ceiling 1 of the building. Examples of the buffer BF include a side track buffer arranged below and to the side of the track TA and an under-track buffer arranged directly below the track TA.

When an article W is to be unloaded at the unloading port PT1, the in-vehicle controller VC instructs the transport vehicle V to stop so as to align with the unloading port PT1 and causes the lift driver 7, or the lift driver 7 and the lateral extender 8 to operate and move the article holder 6 to a predetermined position, to thereby unload the article W at the unloading port PT1. The unloading port PT1 can be arbitrarily set in the transport system SYS. Examples of the unloading port PT1 include a load port of the processing apparatus PA or the stocker ST, and the buffer BF provided with a shelf, on which an article W can be placed, suspended from the ceiling 1 of the building.

The controller TC and the in-vehicle controller VC are connected to communicate with each other in a wireless manner via a transmission path such as wireless LAN (Local Area Network) or feeder communication using a feeder line. The controller TC and the host controller MC are connected to communicate with each other via a transmission line such as a wired LAN or a wireless LAN.

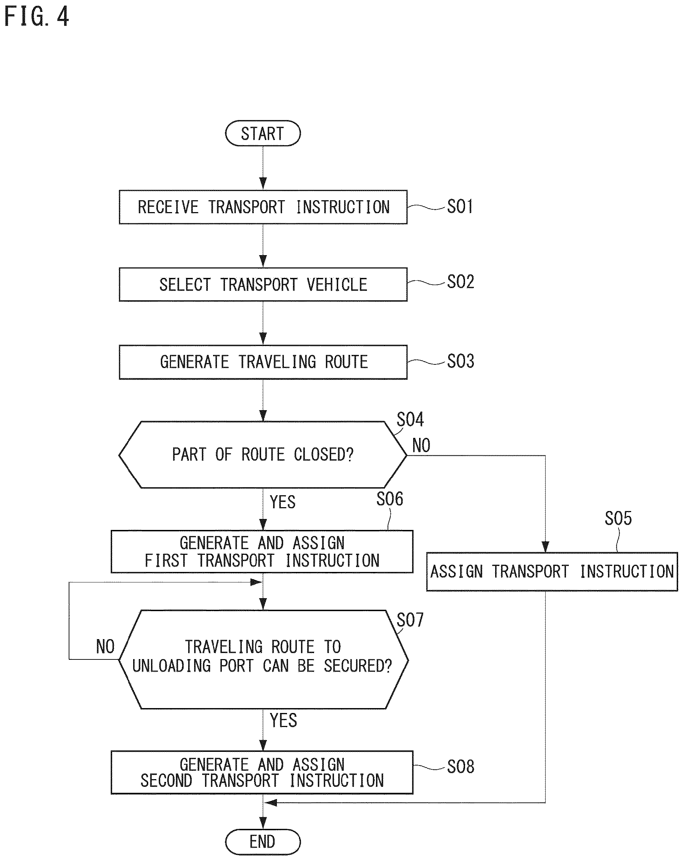

Fig. 4 is a diagram showing an example of the operation flow of the controller TC. Here, the operations performed when the controller TC assigns a transport instruction will be described, with reference to the operation flow shown in Fig. 4. In the description of this operation flow, reference will be made to Fig. 1 to Fig. 3 where appropriate. In the case of transporting an article W present at the pickup port PF1 to the unloading port PT1, the host controller MC transmits to the controller TC a transport instruction (host transport instruction) that instructs that a pickup target article W is present at the pickup port PF1 and that the pickup target article W is to be transported to the unloading port PT1.

The transport instruction receiver 41 of the controller TC receives the transport instruction from the host controller MC (Step S01). The transport instruction receiver 41 determines whether the data received from the host controller MC is a transport instruction by making reference to the header of the data received from the host controller MC, for example. After having received the transport instruction, the transport vehicle selector 42 of the controller TC selects a transport vehicle V to which the transport instruction is to be assigned (Step S02). The traveling route generator 43 generates a traveling route for the transport vehicle V from the pickup port PF1 to the unloading port PT1 on the basis of the received transport instruction (Step S03).

The route determiner 44 determines whether or not a part of the traveling route is closed on the traveling route generated by the traveling route generator 43 (Step S04). If closure is not determined in Step S04 (Step S04; NO), a transport instruction including the traveling route generated by the traveling route generator 43 is assigned to the transport vehicle V (Step S05).

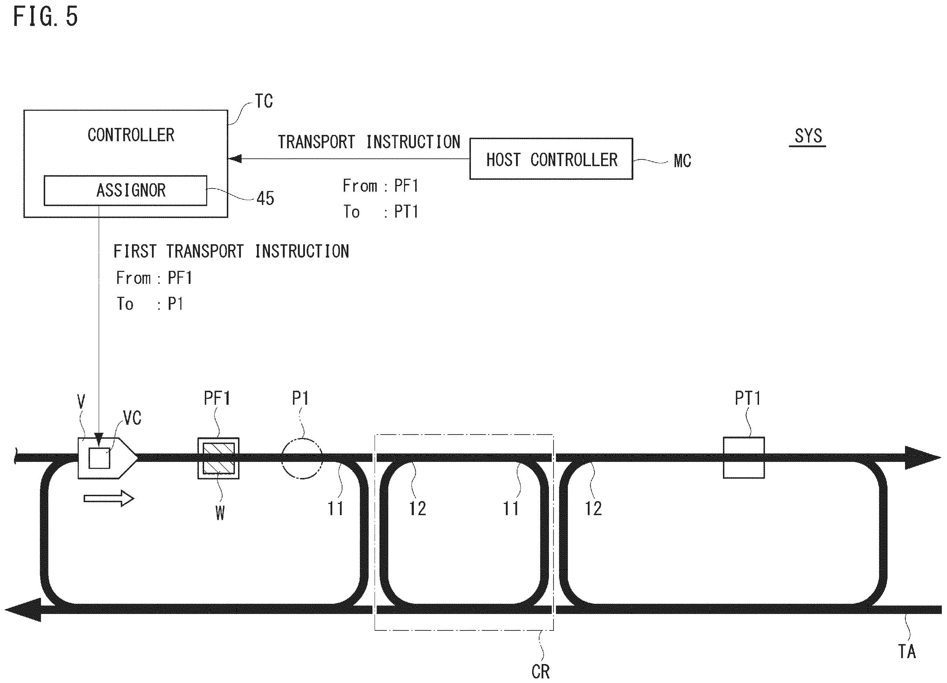

On the other hand, in Step S04, if it is determined that a part of the traveling route is closed and that no transport vehicle V that can execute the transport instruction from the host controller MC (that is, no transport vehicle V that can transport an article W from the pickup port PF1 to the unloading port PT1 designated in the transport instruction) is present within a predetermined range (Step S04; YES), a first transport instruction, instead of the transport instruction from the host controller MC, is assigned to the transport vehicle V (Step S06). Fig. 5 is a diagram showing an example of the operation of the transport vehicle V. As shown in Fig. 5, in the case where a closed route CR is set in a part of the traveling route on the track TA, the assignor 45 assigns to the transport vehicle V the first transport instruction that sets the transport origin (From) as the pickup port PF1 and the transport destination (To) as the specified point P1. Upon receiving the first transport instruction, the transport vehicle V, according to the first transport instruction, picks up the article W at the pickup port PF1 and then travels toward the specified point P1.

At the point in time at which the transport vehicle V has approached or reached the specified point P1, the route determiner 44 determines whether or not a traveling route from the specified point P1 to the unloading port PT1 can be secured (Step S07). If it is determined in Step S07 that a traveling route can be secured (Step S07; YES), a second transport instruction is assigned to the transport vehicle V (Step S08).

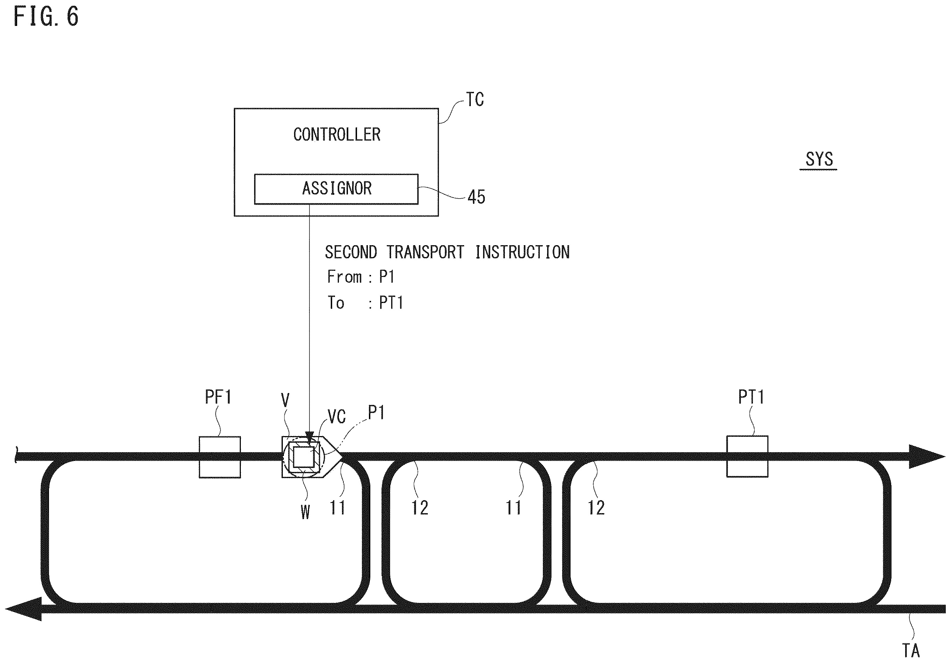

Fig. 6 is an explanatory diagram, which follows Fig. 5, showing an example of the operation of the transport vehicle V. As shown in Fig. 6, at the point in time at which the transport vehicle V reaches the specified point P1, the closed route CR has been lifted and traveling is allowed. Therefore, there is no closed route on the traveling route for the transport vehicle V from the specified point P1 to the unloading port PT1, and the traveling route can be secured. In such a case, the assignor 45 assigns to the transport vehicle V the second transport instruction that sets the transport origin (From) as the specified point P1 or the transport vehicle V itself and the transport destination (To) as the unloading port PT1. If the second transport instruction is received, the transport vehicle V, according to the second transport instruction, travels from the specified point P1 toward the unloading port PT1.

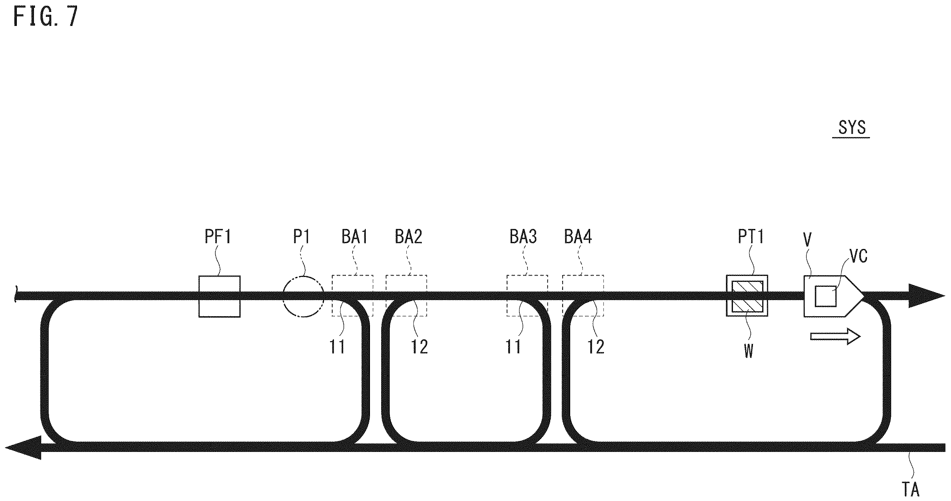

Fig. 7 is an explanatory diagram, which follows Fig. 6, showing an example of the operation of the transport vehicle V. As shown in Fig. 7, when traveling from the specified point P1 toward the unloading port PT1 through the branching part 11 and the merging part 12, the transport vehicle V is to pass through the blocking areas BA1 to BA4. When the transport vehicle V is to pass through the blocking areas BA1 to BA4, the transport vehicle V transmits a passage request for the blocking areas BA1 to BA4 to a blocking controller not shown in the drawings. The transport vehicle V will pass through the blocking areas BA1 to BA4 if a passage permission is received from the blocking controller. Upon arriving at the unloading port PT1, the transport vehicle V unloads the article W. It should be noted that Fig. 7 shows a state where the transport vehicle V has moved to the downstream side after the article W has been unloaded at the unloading port PT1.

If it is determined in Step S07 that the traveling route cannot be secured (Step S07; NO), the transport vehicle V is brought into a stop state at the specified point P1. Since the first transport instruction is an instruction to hold but not unload the article W, it does not allow the article W to be unloaded even if the transport vehicle V arrives at the specified point P1.

As described above, according to the present embodiment, in the case where the traveling route for the transport vehicle V from the pickup port PF1 to the unloading port PT1 designated by the transport instruction cannot be secured on the track TA, the first transport instruction causes the transport vehicle V to pick up the article W at the pickup port PF1 and then travel to the specified point P. Therefore, the article W can be quickly transported out from the pickup port PF1, and another article W can be placed at the pickup port PF1 from which the article W has been transported out. As a result, it is possible to prevent a reduction in the efficiency of the processing of the processing apparatus PA or the like.

In the case where it becomes possible to secure a traveling route to the unloading port PT1 before the transport vehicle V approaches or reaches the specified point P, the second transport instruction causes the transport vehicle V to travel straight to the unloading port PT1 and unloads the article W at the unloading port PT1. As a result, the amount of time taken to transport the article W is reduced and the efficiency of transporting articles W can be improved compared to the case where a transport instruction is assigned to a transport vehicle V when the entire traveling route for the transport vehicle V has been secured. The present embodiment corresponds to a configuration in which a host transport instruction from the host controller MC is divided into a first transport instruction and a second transport instruction by the controller TC, and the second transport instruction is assigned to the transport vehicle V after the first transport instruction has been assigned to the transport vehicle V.

### Second Embodiment

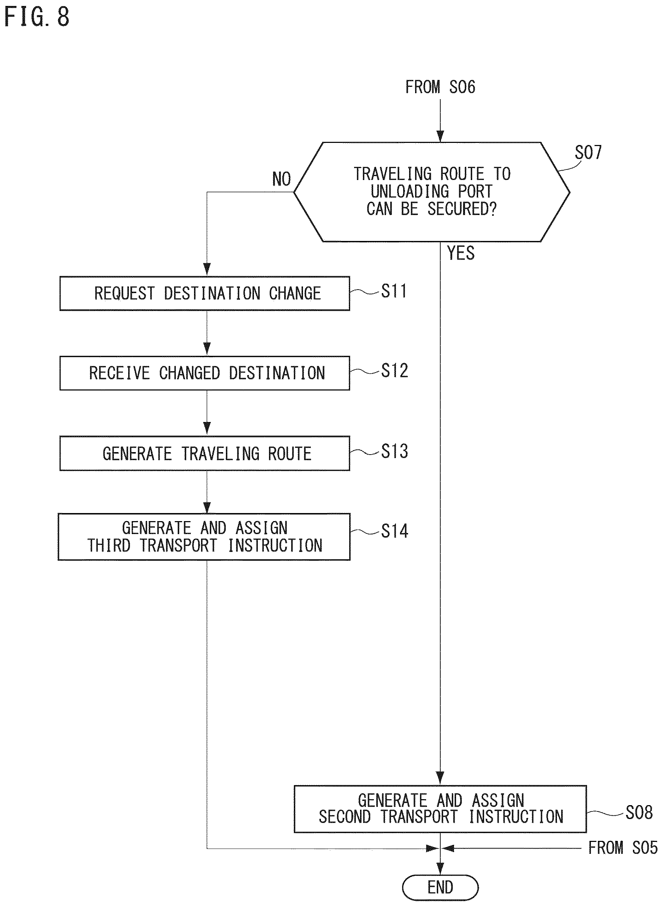

Next, a second embodiment is described. Fig. 8 is a diagram showing an example of the operation flow of a controller TC according to the second embodiment. In the operation flow shown in Fig. 8, the operations of Step S01 to Step S06, YES of Step S07, and Step S08 are similar to those in the operation flow of the above embodiment. In the present embodiment, as shown in Fig. 8, if it is determined in Step S07 that a traveling route cannot be secured (Step S07; NO), the destination change requester 49 reports to the host controller MC that the destination of the transport vehicle V having received the first transport instruction has been changed to the specified point P1, and requests the host controller MC to newly determine an unloading port for the article W, taking the specified point P1 as a reference (Step S11). The host controller MC determines a new unloading port PT2 for the article W on the basis of the request from the destination change requester 49, and transmits the determination content related to the new unloading port PT2 for the article W to the controller TC.

The controller TC receives a new transport instruction related to the new unloading port PT2 for the article W (Step S12). Upon receiving the new transport instruction, the controller TC generates, in the traveling route generator 43, a traveling route from the specified point P1 to the unloading port PT2 (Step S13). It should be noted that, after Step S13, the route determiner 44 may determine whether or not a traveling route from the specified point P1 to the unloading port PT2 can be secured. The assignor 45 assigns to the transport vehicle V a third transport instruction that causes the transport vehicle V to travel from the specified point P1 to the unloading port PT2 and perform unloading at the unloading port PT2 (Step S14).

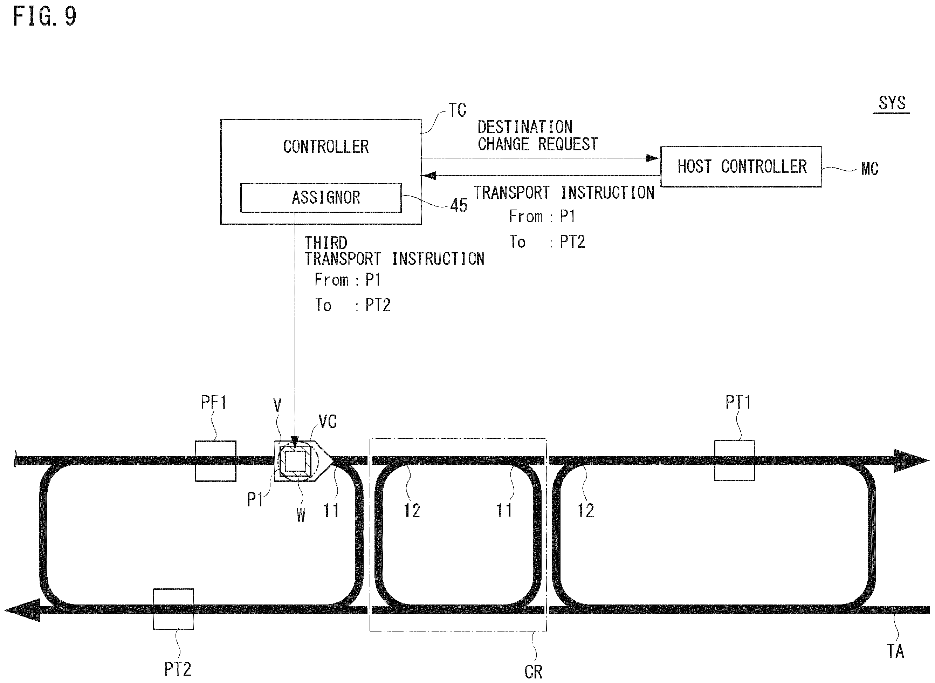

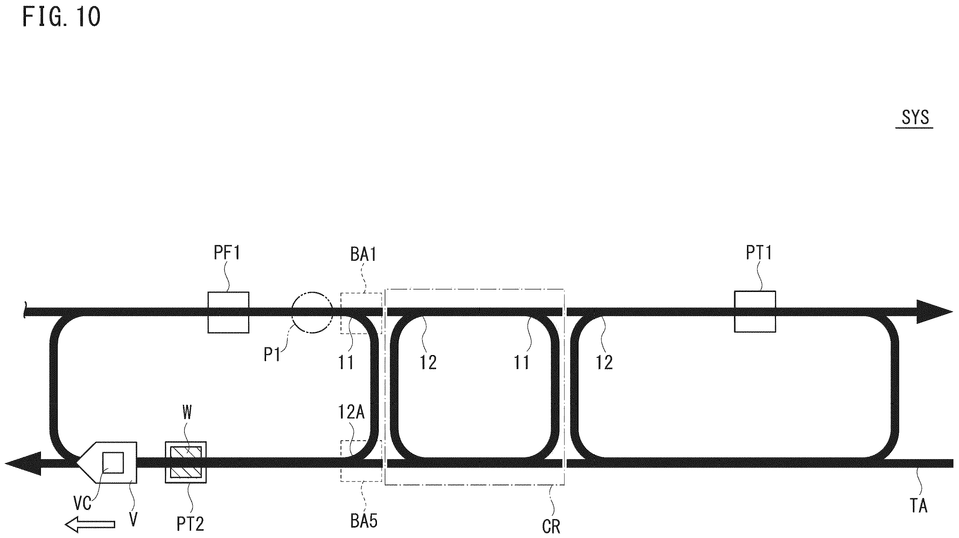

Figs. 9 and 10 are explanatory diagrams showing an example of the operation of the transport vehicle V in the second embodiment. As shown in Fig. 9, at the point in time at which the transport vehicle V reaches the specified point P1, the closed route CR still remains as it was set. In such a case, the destination change requester 49 requests the host controller MC to change the destination as in Step S11 above. In response to this request, the host controller MC transmits to the controller TC a transport instruction (host transport instruction) that designates the transport origin (From) as the specified point P1 and the transport destination (To) as the unloading port PT2.

Upon receiving the transport instruction, on the basis of this transport instruction, the controller TC generates and assigns to the transport vehicle V a third transport instruction that designates the transport origin (From) as the specified point P1 and the transport destination (To) as the unloading port PT2. Upon receiving the third transport instruction, the transport vehicle V, according to the third transport instruction, travels from the specified point P1 to the unloading port PT2 through the branching part 11 and the merging part 12A, and unloads the article W at the unloading port PT2 as shown in Fig. 10. In such a case, the transport vehicle V passes through the blocking areas BA1, BA5. When the transport vehicle V is to pass through the blocking areas BA1, BA5, the transport vehicle V transmits a passage request for the blocking areas BA1, BA5 to a blocking controller not shown in the drawings. The transport vehicle V will pass through the blocking areas BA1, BA5 if a passage permission is received from the blocking controller. It should be noted that Fig. 10 shows a state where the transport vehicle V has moved to the downstream side after the article W has been unloaded at the unloading port PT2.

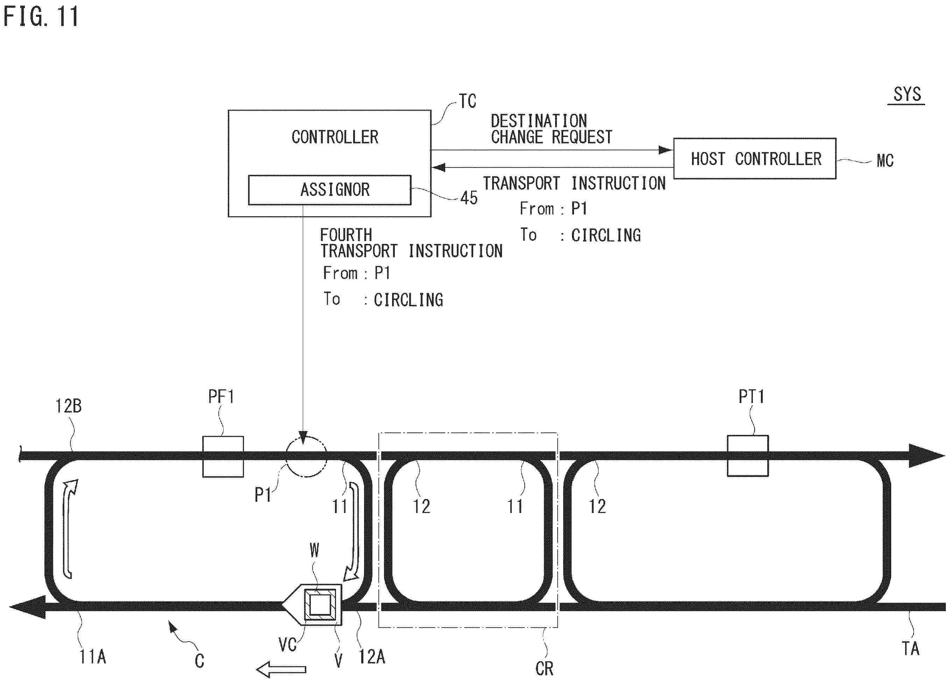

Fig. 11 is an explanatory diagram showing another example of the operation of the transport vehicle V. As shown in Fig. 11, this example is similar to the example described above in that the closed route CR is set in the state where the transport vehicle V has reached the specified point P1. In such a case, the destination change requester 49 requests the host controller MC to change the destination. In response to this request, the host controller MC may transmit to the controller TC a transport instruction (host transport instruction) that designates the transport origin (From) as the specified point P1 and the transport destination (To) as circling travel.

Upon receiving the transport instruction, on the basis of this transport instruction, the controller TC generates and assigns to the transport vehicle V a fourth transport instruction (or fourth special transport instruction; the terms "fourth transport instruction" and "fourth special transport instruction are used synonymously herein) that designates the transport origin (From) as the specified point P1 and the transport destination (To) as a circling route C (circling travel). Upon receiving the fourth transport instruction, according to the fourth transport instruction, the transport vehicle V travels along the circling route C from the specified point P1 through the branching part 11, the merging part 12A, the branching part 11A, and the merging part 12B, while holding the article **W.** In the case where information that indicates the closed route CR having become available for traveling while the transport vehicle V is traveling along the circling route C, the controller TC may assign to the transport vehicle V a fifth transport instruction (or fifth special transport instruction; the terms "fifth transport instruction" and "fifth special transport instruction are used synonymously herein) that designates the transport origin as the circling route C and the transport destination as the unloading port PT1.

The controller TC may request the host controller MC to change the destination by means of the destination change requester 49 after the transport vehicle V has traveled in circles along the circling route C for a predetermined length of time. In response to this request, the host controller MC may transmit to the controller TC a transport instruction (host transport instruction) that designates the transport origin (From) as the circling route C and the transport destination (To) as the unloading port PT2.

As described above, according to the present embodiment, even in the case where the second transport instruction cannot be assigned to the transport vehicle V (where the closed route CR remains set), it is possible to avoid the transport vehicle V from remaining in a stop state at the specified point P1, and avoid the transport vehicle V from causing hindrance to another transport vehicle V passing through the specified point P1.

### Third Embodiment

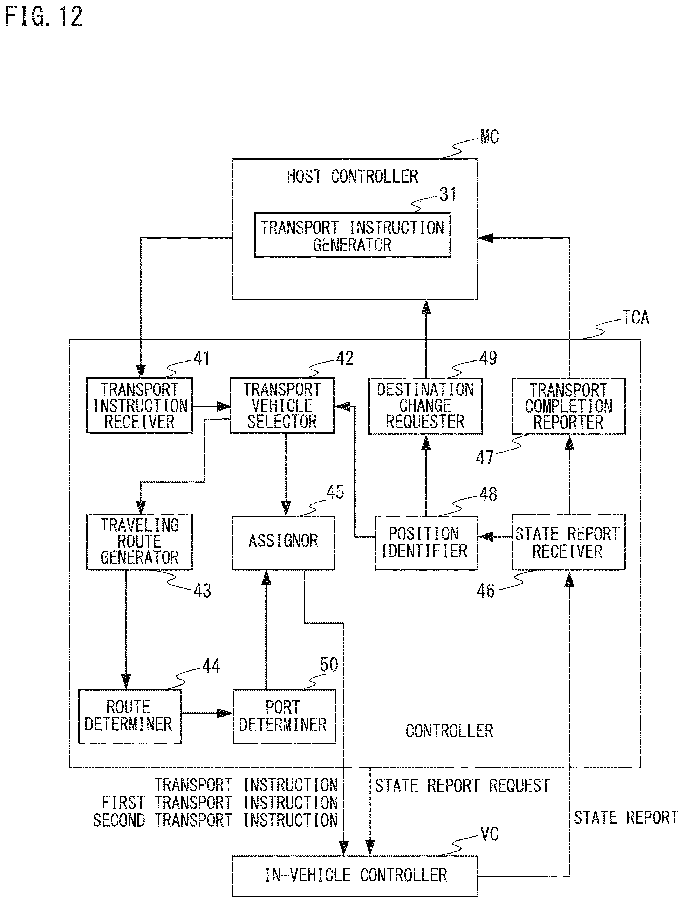

Fig. 12 is a diagram showing an example of a functional block configuration of the host controller MC and a controller TCA according to a third embodiment. As shown in Fig. 12, the controller TCA includes a port determiner 50 in addition to the configuration of the controller TC described above. The port determiner 50 determines the type of at least one of the pickup port PF1 being the transport origin and the unloading port PT1 being the transport destination.

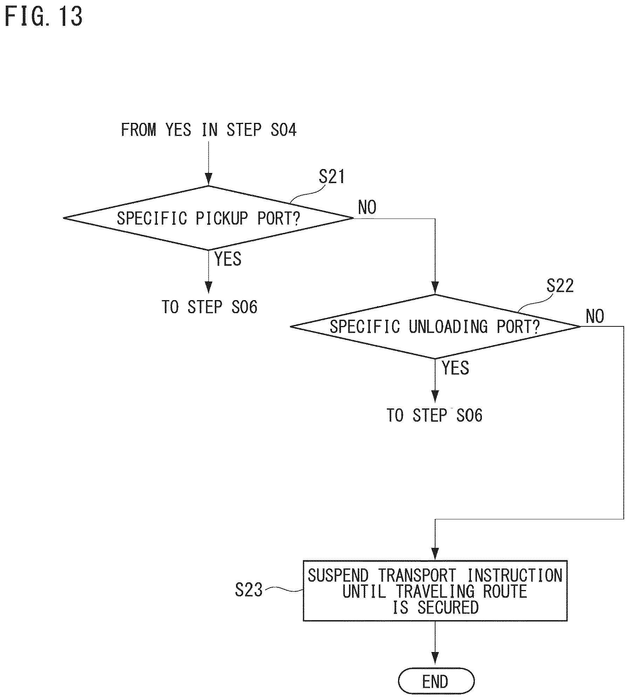

Fig. 13 is a diagram showing an example of the operation flow of the controller TCA according to the third embodiment. In the operation flow shown in Fig. 13, the flow of Step S01 to Step S03, NO of Step S04, Step S05 and thereafter are similar to that in the operation flow of the above embodiment. In the operation flow of the present embodiment, if it is determined in Step S04 that a part of the traveling route is closed (Step S04; YES), the port determiner 50 determines whether or not the pickup port PF1 is a specified pickup port (Step S21).

If the pickup port PF1 is a specific pickup port (Step S21; YES), the assignor 45 assigns a first transport instruction to the transport vehicle V (Step S06). If the pickup port PF1 is not a specified pickup port (Step S21; NO), the port determiner 50 determines whether or not the unloading port PT1 is a specified unloading port (Step S22).

If the unloading port PT1 is a specific unloading port (Step S22; YES), the assignor 45 assigns a first transport instruction to the transport vehicle V (Step S06). If the unloading port PT1 is not a specific unloading port (Step S22; NO), the assignor 45 suspends the transport instruction until the traveling route can be secured (Step S23).

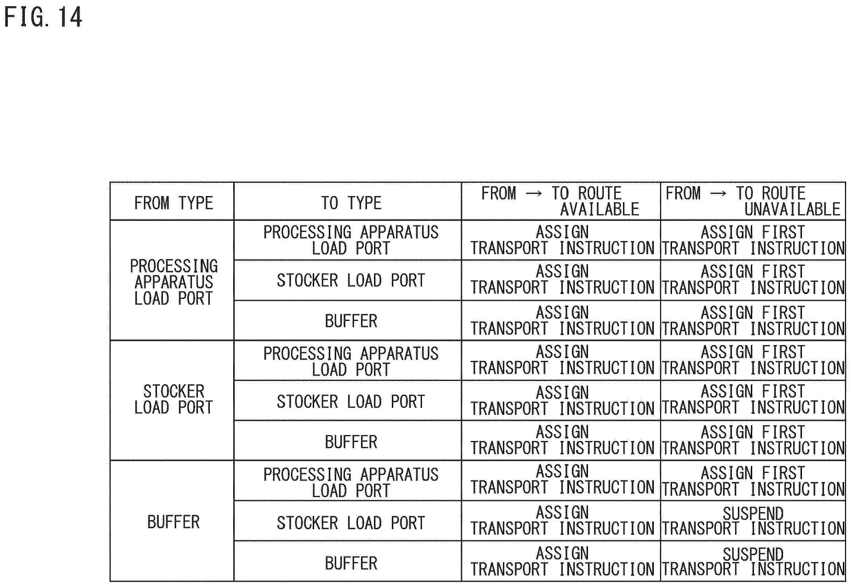

Fig. 14 is a table showing the relationship between the types of the pickup port PF1 and unloading port PT1 in the determinations of Step S21 and Step S22, and the types of transport instructions to be assigned. As shown in Fig. 14, in the case where the pickup port PF1 is a load port of the processing apparatus PA (see Fig. 3) or a load port of the stocker ST (see Fig. 3), the first transport instruction is assigned when a traveling route cannot be secured, regardless of the type of the unloading port PT1. In the case where the pickup port PF1 is a buffer BF, the type of the instruction to be assigned differs, depending on the type of the unloading port PT1. That is to say, in the case where the type of the unloading port PT1 is a load port of the processing apparatus PA, a first transport instruction is assigned when the traveling route cannot be secured.

In the case where the type of the unloading port PT1 is a load port of a stocker ST or a buffer BF (see Fig. 3), assignment of the transport instruction is suspended when the traveling route cannot be secured. That is to say, neither the transport instruction nor the first transport instruction is assigned to the transport vehicle V, and the transport instruction from the host controller MC is suspended in the controller TC. As shown in the table of Fig. 14, when a traveling route can be secured, a normal transport instruction is assigned to the transport vehicle V in any case.

As described above, according to the present embodiment, the first transport instruction causes an article W to be transported out quickly from the pickup port PF1 (processing apparatus PA, stocker ST) from which articles W are required to be transported out promptly, and therefore, the next article W can be placed at the pickup port PF1 (processing apparatus PA, stocker ST) from which an article W has already been transported out, and a reduction can be avoided in the utilization rate of the processing apparatus PA or the stocker ST.

In the case where the pickup port PF1 is a buffer BF on which an article W can be placed and the unloading port PT1 is a load port of the processing apparatus PA, the controller TC assigns a first transport instruction and a second transport instruction, and therefore, an article W can be transported to the load port of the processing apparatus PA in a short period of time. In the case where the pickup port PF1 is a buffer BF and the unloading port PT1 is other than a load port of the processing apparatus PA, a first transport instruction and a second transport instruction are not assigned, and therefore, the processing load on the controller TC can be reduced.

### Fourth Embodiment

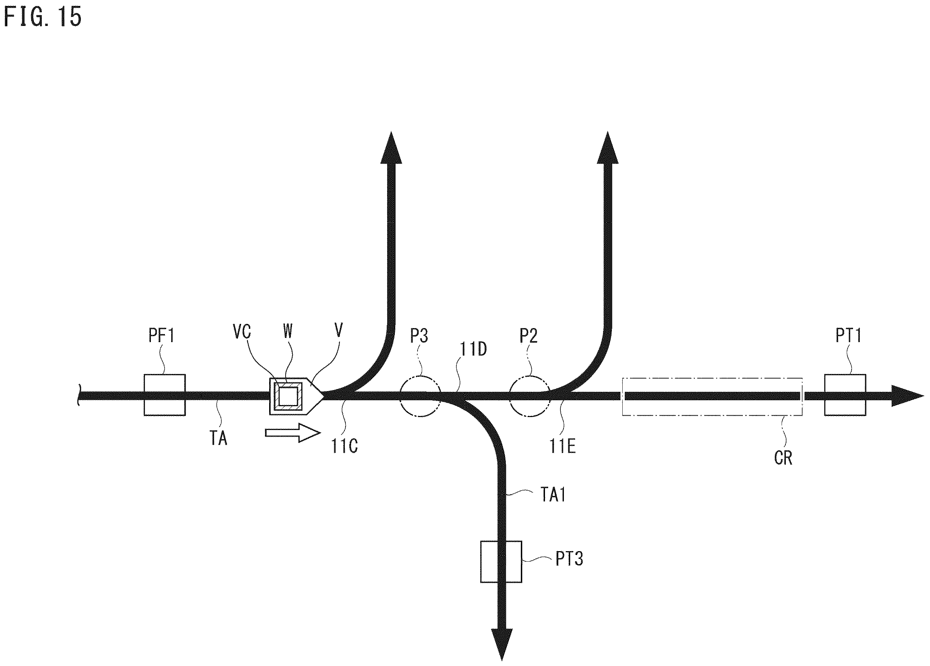

Fig. 15 is an explanatory diagram showing an example of the operation of the transport vehicle V in a fourth embodiment. The track TA shown in Fig. 15 includes a branching part 11C, a branching part 11D, and a branching part 11E on the downstream side of the pickup port PF1. A closed route CR is set on the downstream side of the branching part 11E, and the unloading port PT1 is arranged on the downstream side of the closed route CR.

In the above embodiment, the specified point P1 is set immediately before the branching part 11 closest to the pickup port PF1; however, the invention is not limited to this example. For example, a specified point P2 may be set immediately before the branching part 11E closest to the closed path CR. In such a case, the transport vehicle V travels to the specified point P2 and then stops, and accordingly, the transport vehicle V stands by at a position closest possible to the unloading port PT1. As a result, when the closed route CR is lifted, the transport vehicle V can quickly reach the unloading port PT1 and unload the article W at the unloading port PT1.

A specified point P3 may be set immediately before the branching part 11D, on the track TA1 on the downstream side of which another unloading port PT3 is arranged. In such a case, when requesting a change of destination after a first transport instruction has been assigned, it is possible to unload the article W from the specified point P3 in a short period of time by setting the new destination of the article W as the unloading port PT3 close to the specified point P3. As a result, the next transport instruction can be assigned to the transport vehicle V and a reduction can be prevented in the efficiency of transporting articles W.

The embodiments of the present invention have been described above. However, the technical scope of the invention is not limited to the description of the above embodiments. It is also apparent to those skilled in the art that various modifications or improvements can be added to the above embodiments. The technical scope of the present invention also encompasses one or more of such modifications or improvements. The order of executing processes shown in the present embodiments can be realized in an arbitrary order unless an output of the previous processing is used in the following processing. While operations in the above embodiments have been described with expressions such as "first", "next", and "subsequently" for the sake of convenience, the operations need not always be implemented in that order.

Furthermore, in the above embodiments, the configuration has been described as an example in which a host controller MC and a controller TC are provided in the transport system SYS; however, the present invention is not limited to this configuration. For example, a single controller may include the functions of both the host controller MC and the controller TC. In the above embodiments, the configuration has been described as an example in which the controller TC is provided as a unit separate from the in-vehicle controller VC of the transport vehicle V; however, the invention is not limited to this configuration. For example, the function of the controller TC may be realized as a part of the function of the in-vehicle controller VC.

One or more of the requirements described in the above embodiments may be omitted in some cases. One or more of the requirements described in the above embodiments may be combined where appropriate.

### Description of Reference Signs

P, P1, P2, P3: Specified point
BF: Buffer
V: Transport vehicle
W: Article
MC: Host controller
TA, TA1: Track
CR: Closed route
TC, TCA: Controller (transport controller)
PF1: Pickup port
PT1, PT2, PT3: Unloading port
VC: In-vehicle controller
SYS: Transport system
11, 11A, 11D, 11E: Branching part
12, 12A, 12B: Merging part
31: Transport instruction generator
41: Transport instruction receiver
42: Transport vehicle selector
43: Traveling route generator
44: Route determiner
45: Assignor
46: State report receiver
47: Transport completion reporter
48: Position identifier
49: Destination change requester
50: Port determiner

## Claims

1. A transport system (SYS) comprising:
a plurality of transport vehicles (V) that are adapted to travel along a track (TA;TA1); and
a controller (TC;TCA) that is adapted to control a transport vehicle (V), wherein
the controller (TC;TCA) is adapted to assign normal transport instructions comprising an instruction for the transport vehicle (V) to pick up an article (W) at a pickup port (PF1) and travel from the pickup port (PF1) to an unloading port (PT1;PT2;PT3) along a travelling route and to unload the article (W) at the unloading port (PT1;PT2;pt3);
**characterized in that**
the controller (TC;TCA) is adapted to obtain closure information related to closure of the travelling route and to assign a normal transport instruction to the transport vehicle (V) only if the traveling route for the transport vehicle (V) from the pickup port (PF) to the unloading port (PT1;PT2;PT3) can be secured on the track (TA;TA1);
the controller (TC;TCA) is further adapted to assign a first special transport instruction to cause the transport vehicle (V) to pick up the article (W) at the pickup port (PF) and travel to a specified point (P1;P2;P3) on the downstream side of the pickup port (PF) in a traveling direction of the transport vehicle (V) at which a traveling route can be secured on the track,instead of a normal transport instruction, in a case where the traveling route for the transport vehicle (V) from the pickup port (PF) to the unloading port (PT1;PT2;PT3) designated by the transport instruction cannot be secured on the track (TA;TA1), and
the controller (TC;TCA) is further adapted to assign a second special transport instruction to cause the transport vehicle (V) to travel from the specified point (P1;P2;P3) to the unloading port (PT1;PT2;PT3) and to unload the article (W) at the unloading port (PT1;PT2;PT3), in a case where a traveling route from the specified point (P1;P2;P3) to the unloading port (PT1;PT2;PT3) can be secured at the point in time at which the transport vehicle (V) approaches or reaches the specified point (P1;P2;P3) based on the above-described closure information.

2. The transport system (SYS) according to claim 1, wherein
the first special transport instruction is an instruction to cause the transport vehicle (V) to travel to the specified point (P1;P2;P3) and hold but not unload the article (W).

3. The transport system (SYS) according to claim 1 or 2, wherein
the specified point (P1;P2;P3) is set immediately before a branching part (11;11A;11C;11D;11E) or a merging part (12;12A;12B) on the track (TA;TA1).

4. The transport system (SYS) according to claim 3, wherein
in the case where the specified point (P1;P2;P3) is set immediately before the branching part (11;11A;11C;11D;11E),
the branching part (11;11A;11C;11D;11E) is a branching part (11;11A;11C;11D;11E) closest to the pickup port (PF1).

5. The transport system (SYS) according to any one of claims 1 to 4, wherein
the controller (TC;TCA) is adapted to determine whether or not to assign the first special transport instruction and the second special transport instruction, according to the type of at least one of the pickup port (PF1) and the unloading port (PT1;PT2;PT3).

6. The transport system (SYS) according to claim 5, wherein
the controller (TC;TCA) is adapted to assign the first special transport instruction and the second special transport instruction to the transport vehicle (V) in the case where the pickup port (PF1) is a load port of a processing apparatus (PA).

7. The transport system (SYS) according to claim 5, wherein
the controller (TC;TCA) is adapted to assign the first special transport instruction and the second special transport instruction to the transport vehicle (V) in the case where the pickup port (PF1) is a load port of a stocker (ST).

8. The transport system (SYS) according to claim 5, wherein
the controller (TC;TCA) is adapted to assign the first special transport instruction and the second special transport instruction in the case where the pickup port (PF1) is a buffer (BF), on which an article (W) can be placed, and the unloading port (PT1;PT2;PT3) is a load port of a processing apparatus (PA), and the controller (TC;TCA) is adapted to not assign the first special transport instruction and the second special transport instruction in the case where the pickup port (PF1) is the buffer (BF) and the unloading port (PT1;PT2;PT3) is other than a load port of a processing apparatus (PA).

9. The transport system (SYS) according to any one of claims 1 to 8, wherein
the controller (TC;TCA) is a transport controller that is adapted to control a plurality of the transport vehicles (V), or an in-vehicle controller (VC) fitted in the transport vehicle (V).

10. The transport system (SYS) according to any one of claims 1 to 9, wherein
the controller (TC;TCA) is adapted to provide a third special transport instruction to cause the transport vehicle (V) to travel from the specified point (P1;P2;P3) to a new unloading port and unload the article (V) at the new unloading port, in a case where the travelling route from the specified point (P1;P2;P3) to the unloading port (PT1;PT2;PT3) cannot be secured at the time when the transport vehicle (V) approaches or reaches the specified point (P1;P2;P3).

11. A transport control method for controlling a transport system (SYS) comprising a plurality of transport vehicles (V) traveling along a track (TA;TA1), the method being **characterised by** the following steps of:
obtaining closure information related to closure of a travelling route from a pickup port (PF1) to an unloading port (PT1;PT2;PT3);
assigning a normal transport instruction comprising an instruction for a transport vehicle (V) to pick up an article (W) at the pickup port (V), to travel from a pickup port (PF1) to the unloading port (PT1;PT2;PT3) along the travelling route and to unload the article (W) at the unloading port (PT1;PT2;PT3), only if the traveling route for the transport vehicle (V) from the pickup port (PF) to the unloading port (PT1;PT2;PT3) can be secured on the track (TA;TA1);
assigning a first special transport instruction, to cause the transport vehicle (V) to pick up an article (W) at a pickup port (PF1) and travel to a specified point (P1;P2;P3) on the downstream side of the pickup port (PF1) in a traveling direction of the transport vehicle (V) at which a traveling route can be secured on the track (TA;TA1), instead of a normal transport instruction, in a case where a traveling route for the transport vehicle (V) from a pickup port (PF1) to an unloading port (PT1;PT2;PT3) designated by the transport instruction cannot be secured on the track (TA;TA1); and
assigning a second special transport instruction to cause the transport vehicle (V) to travel from the specified point (P1;P2;P3) to the unloading port (PT1;PT2;PT3) and to unload the article at the unloading port (PT1;PT2;PT3), in a case where a traveling route from the specified point (P1;P2;P3) to the unloading port (PT1;PT2;PT3) can be secured at the point in time at which the transport vehicle (V) approaches or reaches the specified point (P1;P2;P3) based on the above-described closure information.

## Patentansprüche

1. Transportsystem (SYS), umfassend:
eine Mehrzahl von Transportfahrzeugen (V), welche dazu eingerichtet sind, entlang einer Spur (TA; TA1) zu fahren; und
eine Steuereinrichtung (TC; TCA), welche dazu eingerichtet ist, ein Transportfahrzeug (V) zu steuern, wobei
die Steuereinrichtung (TC; TCA) dazu eingerichtet ist, normale Transportanweisungen zuzuweisen, welche eine Anweisung für das Transportfahrzeug (V) umfassen, einen Gegenstand (W) an einer Abholschnittstelle (PF1) abzuholen und entlang eines Fahrwegs von der Abholschnittstelle (PF1) zu einer Entladeschnittstelle (PT1; PT2; PT3) zu fahren und den Gegenstand (W) an der Entladeschnittstelle (PT1; PT2; pt3) zu entladen;
**dadurch gekennzeichnet, dass**
die Steuereinrichtung (TC; TCA) dazu eingerichtet ist, Schließinformationen zu erhalten, welche ein Schließen des Fahrwegs betreffen, und dem Transportfahrzeug (V) nur dann eine normale Transportanweisung zuzuweisen, wenn der Fahrweg für das Transportfahrzeug (V) von der Abholschnittstelle (PF) zu der Entladeschnittstelle (PT1; PT2; PT3) auf der Spur (TA; TA1) gesichert werden kann;
die Steuereinrichtung (TC; TCA) ferner dazu eingerichtet ist, eine erste spezielle Transportanweisung zuzuweisen, um zu veranlassen, dass das Transportfahrzeug (V) den Gegenstand (W) an der Abholschnittstelle (PF) abholt und zu einem spezifizierten Punkt (P1; P2; P3) auf der in einer Fahrrichtung des Transportfahrzeugs (V) der Abholschnittstelle (PF) nachgelagerten Seite fährt, an welchem ein Fahrweg auf der Spur gesichert werden kann, anstelle einer normalen Transportanweisung, in einem Fall, in welchem der durch die Transportanweisung vorgesehene Fahrweg für das Transportfahrzeug (V) von der Abholschnittstelle (PF) zu der Entladeschnittstelle (PT1; PT2; PT3) nicht auf der Spur (TA; TA1) gesichert werden kann, und
die Steuereinrichtung (TC; TCA) ferner dazu eingerichtet ist, eine zweite spezielle Transportanweisung zuzuweisen, um zu veranlassen, dass das Transportfahrzeug (V) von dem spezifizierten Punkt (P1; P2; P3) zu der Entladeschnittstelle (PT1; PT2; PT3) fährt und den Gegenstand (W) an der Entladeschnittstelle (PT1; PT2; PT3) entlädt, in einem Fall, in welchem ein Fahrweg von dem spezifizierten Punkt (P1; P2; P3) zu der Entladeschnittstelle (PT1; PT2; PT3) gesichert werden kann, zu dem Zeitpunkt, zu welchem sich das Transportfahrzeug (V) dem spezifizierten Punkt (P1; P2; P3) nähert oder ihn erreicht, auf Grundlage der oben beschriebenen Schließinformationen.

2. Transportsystem (SYS) nach Anspruch 1, wobei
die erste spezielle Transportanweisung eine Anweisung ist, um zu veranlassen, dass das Transportfahrzeug (V) zu dem spezifizierten Punkt (P1; P2; P3) fährt und anhält, aber den Gegenstand (W) nicht entlädt.

3. Transportsystem (SYS) nach Anspruch 1 oder 2, wobei
der spezifizierte Punkt (P1; P2; P3) unmittelbar vor einem Abzweigungsteil (11; 11A; 11C; 11D; 11E) oder einem Zusammenführungsteil (12; 12A; 12B) auf der Spur (TA; TA1) gesetzt ist.

4. Transportsystem (SYS) nach Anspruch 3, wobei
in dem Fall, in welchem der spezifizierte Punkt (P1; P2; P3) unmittelbar vor dem Abzweigungsteil (11; 11A; 11C; 11D; 11E) gesetzt ist,
der Abzweigungsteil (11; 11A; 11C; 11D; 11E) ein Abzweigungsteil (11; 11A; 11C; 11D; 11E) ist, welcher der Abholschnittstelle (PF1) am nächsten ist.

5. Transportsystem (SYS) nach einem der Ansprüche 1 bis 4, wobei
die Steuereinrichtung (TC; TCA) dazu eingerichtet ist, zu bestimmen, ob die erste spezielle Transportanweisung und die zweite spezielle Transportanweisung zugewiesen werden oder nicht, gemäß dem Typ wenigstens einer der Abholschnittstelle (PF1) und der Entladeschnittstelle (PT1; PT2; PT3).

6. Transportsystem (SYS) nach Anspruch 5, wobei
die Steuereinrichtung (TC; TCA) dazu eingerichtet ist, dem Transportfahrzeug (V) die erste spezielle Transportanweisung und die zweite spezielle Transportanweisung zuzuweisen, in dem Fall, in welchem die Abholschnittstelle (PF1) eine Beladeschnittstelle einer Verarbeitungsvorrichtung (PA) ist.

7. Transportsystem (SYS) nach Anspruch 5, wobei
die Steuereinrichtung (TC; TCA) dazu eingerichtet ist, dem Transportfahrzeug (V) die erste spezielle Transportanweisung und die zweite spezielle Transportanweisung zuzuweisen, in dem Fall, in welchem die Abholschnittstelle (PF1) eine Beladeschnittstelle einer Stapeleinrichtung (ST) ist.

8. Transportsystem (SYS) nach Anspruch 5, wobei
die Steuereinrichtung (TC; TCA) dazu eingerichtet ist, die erste spezielle Transportanweisung und die zweite spezielle Transportanweisung zuzuweisen, in dem Fall, in welchem die Abholschnittstelle (PF1) ein Zwischenspeicher (BF) ist, an welchem ein Gegenstand (W) platziert werden kann, und die Entladeschnittstelle (PT1; PT2; PT3) eine Beladeschnittstelle einer Verarbeitungsvorrichtung (PA) ist, und die Steuereinrichtung (TC; TCA) dazu eingerichtet ist, die erste spezielle Transportanweisung und die zweite spezielle Transportanweisung nicht zuzuweisen, in dem Fall, in welchem die Abholschnittstelle (PF1) der Zwischenspeicher (BF) ist und die Entladeschnittstelle (PT1; PT2; PT3) von einer Beladeschnittstelle einer Verarbeitungsvorrichtung (PA) verschieden ist.

9. Transportsystem (SYS) nach einem der Ansprüche 1 bis 8, wobei
die Steuereinrichtung (TC; TCA) eine Transportsteuereinrichtung, welche dazu eingerichtet ist, eine Mehrzahl der Transportfahrzeuge (V) zu steuern, oder eine fahrzeuginterne Steuereinrichtung (VC) ist, welche in dem Transportfahrzeug (V) montiert ist.

10. Transportsystem (SYS) nach einem der Ansprüche 1 bis 9, wobei
die Steuereinrichtung (TC; TCA) dazu eingerichtet ist, eine dritte spezielle Transportanweisung bereitzustellen, um zu veranlassen, dass das Transportfahrzeug (V) von dem spezifizierten Punkt (P1; P2; P3) zu einer neuen Entladeschnittstelle fährt und den Gegenstand (V) an der neuen Entladeschnittstelle entlädt, in einem Fall, in welchem der Fahrweg von dem spezifizierten Punkt (P1; P2; P3) zu der Entladeschnittstelle (PT1; PT2; PT3) nicht gesichert werden kann, zu der Zeit, wenn sich das Transportfahrzeug (V) dem spezifizierten Punkt (P1; P2; P3) nähert oder ihn erreicht.

11. Transportsteuerungsverfahren zum Steuern eines Transportsystems (SYS), welches eine Mehrzahl von Transportfahrzeugen (V) umfasst, welche entlang einer Spur (TA; TA1) fahren, wobei das Verfahren durch die folgenden Schritte gekennzeichnet ist:
Erhalten von Schließinformationen, welche ein Schließen eines Fahrwegs von einer Abholschnittstelle (PF1) zu einer Entladeschnittstelle (PT1; PT2; PT3) betreffen,
Zuweisen einer normalen Transportanweisung, welche eine Anweisung für ein Transportfahrzeug (V) umfasst, einen Gegenstand (W) an der Abholschnittstelle (PF1) abzuholen, entlang des Fahrwegs von einer Abholschnittstelle (PF1) zu der Entladeschnittstelle (PT1; PT2; PT3) zu fahren und den Gegenstand (W) an der Entladeschnittstelle (PT1; PT2; PT3) zu entladen, nur dann, wenn der Fahrweg für das Transportfahrzeug (V) von der Abholschnittstelle (PF) zu der Entladeschnittstelle (PT1; PT2; PT3) auf der Spur (TA; TA1) gesichert werden kann;
Zuweisen einer ersten speziellen Transportanweisung, um zu veranlassen, dass das Transportfahrzeug (V) einen Gegenstand (W) an einer Abholschnittstelle (PF1) abholt und zu einem spezifizierten Punkt (P1; P2; P3) auf der in einer Fahrrichtung des Transportfahrzeugs (V) der Abholschnittstelle (PF1) nachgelagerten Seite fährt, an welchem ein Fahrweg auf der Spur (TA; TA1) gesichert werden kann, anstelle einer normalen Transportanweisung, in einem Fall, in welchem ein durch die Transportanweisung vorgesehener Fahrweg für das Transportfahrzeug (V) von einer Abholschnittstelle (PF1) zu einer Entladeschnittstelle (PT1; PT2; PT3) nicht auf der Spur (TA; TA1) gesichert werden kann; und
Zuweisen einer zweiten speziellen Transportanweisung, um zu veranlassen, dass das Transportfahrzeug (V) von dem spezifizierten Punkt (P1; P2; P3) zu der Entladeschnittstelle (PT1; PT2; PT3) fährt und den Gegenstand an der Entladeschnittstelle (PT1; PT2; PT3) entlädt, in einem Fall, in welchem ein Fahrweg von dem spezifizierten Punkt (P1; P2; P3) zu der Entladeschnittstelle (PT1; PT2; PT3) gesichert werden kann, zu dem Zeitpunkt, zu welchem sich das Transportfahrzeug (V) dem spezifizierten Punkt (P1; P2; P3) nähert oder ihn erreicht, auf Grundlage der oben beschriebenen Schließinformationen.

## Revendications

1. Système de transport (SYS) comprenant :
une pluralité de véhicules de transport (V) qui sont adaptés pour circuler le long d'une voie (TA ; TA1) ; et
un dispositif de commande (TC ;TCA) qui est adapté pour commander un véhicule de transport (V), dans lequel
le dispositif de commande (TC ;TCA) est adapté pour attribuer des instructions de transport normales comprenant une instruction pour que le véhicule de transport (V) saisisse un article (W) au niveau d'un orifice de saisie (PF1) et se déplace depuis l'orifice de saisie (PF1) vers un orifice de déchargement (PT1 ; PT2 ; PT3) le long d'un itinéraire de déplacement et pour qu'il décharge l'article (W) au niveau de l'orifice de déchargement (PT1 ; PT2 ; pt3) ;
**caractérisé en ce que**
le dispositif de commande (TC ; TCA) est adapté pour obtenir des informations de fermeture concernant une fermeture de l'itinéraire de déplacement et pour attribuer une instruction de transport normale au véhicule de transport (V) uniquement si l'itinéraire de déplacement pour le véhicule de transport (V) allant de l'orifice de saisie (PF) à l'orifice de déchargement (PT1 ; PT2 ; PT3) peut être assuré sur la voie (TA ; TA1) ;
le dispositif de commande (TC ; TCA) est en outre adapté pour attribuer une première instruction de transport spéciale pour amener le véhicule de transport (V) à saisir l'article (W) au niveau de l'orifice de saisie (PF) et à se déplacer vers un point spécifié (P1 ; P2 ; P3) sur le côté aval de l'orifice de saisie (PF) dans une direction de déplacement du véhicule de transport (V) au niveau duquel un itinéraire de déplacement peut être assuré sur la voie, au lieu d'une instruction de transport normale, dans un cas où l'itinéraire de déplacement du véhicule de transport (V) allant de l'orifice de saisie (PF) à l'orifice de déchargement (PT1 ; PT2 ; PT3) désigné par l'instruction de transport ne peut pas être assuré sur la voie (TA ; TA1), et
le dispositif de commande (TC ; TCA) est en outre adapté pour attribuer une deuxième instruction de transport spéciale pour amener le véhicule de transport (V) à se déplacer du point spécifié (P1 ; P2 ; P3) à l'orifice de déchargement (PT1 ; PT2 ; PT3) et à décharger l'article (W) au niveau de l'orifice de déchargement (PT1 ; PT2 ; PT3), dans un cas où un itinéraire de déplacement allant du point spécifié (P1 ; P2 ; P3) jusqu'à l'orifice de déchargement (PT1 ; PT2 ; PT3) peut être assuré au moment où le véhicule de transport (V) s'approche ou atteint le point spécifié (P1 ; P2 ; P3) sur la base des informations de fermeture décrites ci-dessus.

2. Système de transport (SYS) selon la revendication 1, dans lequel
la première instruction de transport spéciale est une instruction pour amener le véhicule de transport (V) à se déplacer jusqu'au point spécifié (P1 ; P2 ; P3) et à conserver l'article (W), mais pas à le décharger.

3. Système de transport (SYS) selon la revendication 1 ou 2, dans lequel
le point spécifié (P1 ; P2 ; P3) est établi immédiatement avant une partie d'embranchement (11 ; 11A ;11C ; 11D ; 11E) ou une partie de convergence (12 ; 12A ; 12B) sur la voie (TA ; TA1).

4. Système de transport (SYS) selon la revendication 3, dans lequel
dans le cas où le point spécifié (P1 ; P2 ; P3) est établi juste avant la partie d'embranchement (11 ; 11A ; 11C ; 11D ; 11E),
la partie d'embranchement (11 ; 11A ; 11C ; 11D ; 11E) est une partie d'embranchement (11 ; 11A ; 11C ; 11D ; 11E) la plus proche de l'orifice de saisie (PF1).

5. Système de transport (SYS) selon l'une quelconque des revendications 1 à 4, dans lequel
le dispositif de commande (TC ; TCA) est adapté pour déterminer s'il faut attribuer ou non la première instruction de transport spéciale et la deuxième instruction de transport spéciale, selon le type d'au moins l'un des ports de saisie (PF1) et de déchargement (PT1 ; PT2 ; PT3).

6. Système de transport (SYS) selon la revendication 5, dans lequel
le dispositif de commande (TC ; TCA) est adapté pour attribuer la première instruction de transport spéciale et la deuxième instruction de transport spéciale au véhicule de transport (V) dans le cas où l'orifice de saisie (PF1) est un orifice de charge d'un appareil de traitement (PA).

7. Système de transport (SYS) selon la revendication 5, dans lequel
le dispositif de commande (TC ; TCA) est adapté pour attribuer la première instruction de transport spéciale et la deuxième instruction de transport spéciale au véhicule de transport (V) dans le cas où l'orifice de saisie (PF1) est un orifice de charge d'un stockeur (ST).

8. Système de transport (SYS) selon la revendication 5, dans lequel
le dispositif de commande (TC ; TCA) est adapté pour attribuer la première instruction de transport spéciale et la deuxième instruction de transport spéciale dans le cas où l'orifice de saisie (PF1) est une zone tampon (BF), sur laquelle un article (W) peut être placé, et l'orifice de déchargement (PT1 ; PT2 ; PT3) est un orifice de charge d'un appareil de traitement (PA), et le dispositif de commande (TC ; TCA) est adapté pour ne pas attribuer la première instruction de transport spéciale et la deuxième instruction de transport spéciale dans le cas où l'orifice de saisie (PF1) est la zone tampon (BF) et l'orifice de déchargement (PT1 ; PT2 ; PT3) est autre qu'un orifice de charge d'un appareil de traitement (PA).

9. Système de transport (SYS) selon l'une quelconque des revendications 1 à 8, dans lequel
le dispositif de commande (TC ; TCA) est un dispositif de commande de transport qui est adapté pour commander une pluralité de véhicules de transport (V), ou un dispositif de commande embarqué (VC) installé dans le véhicule de transport (V).

10. Système de transport (SYS) selon l'une quelconque des revendications 1 à 9, dans lequel
le dispositif de commande (TC ; TCA) est adapté pour fournir une troisième instruction de transport spéciale pour amener le véhicule de transport (V) à se déplacer du point spécifié (P1 ; P2 ; P3) à un nouvel orifice de déchargement et à décharger l'article (V) au niveau du nouvel orifice de déchargement, dans un cas où l'itinéraire de déplacement allant du point spécifié (P1 ; P2 ; P3) à l'orifice de déchargement (PT1 ; PT2 ; PT3) ne peut pas être assuré au moment où le véhicule de transport (V) s'approche ou atteint le point spécifié (P1 ; P2 ; P3).

11. Procédé de commande de transport pour commander un système de transport (SYS) comprenant une pluralité de véhicules de transport (V) se déplaçant le long d'une voie (TA ; TA1), le procédé étant **caractérisé par** les étapes suivantes :
l'obtention d'informations de fermeture concernant une fermeture d'un itinéraire de déplacement allant d'un orifice de saisie (PF1) à un orifice de déchargement (PT1 ; PT2 ; PT3) ;
l'attribution d'une instruction de transport normale comprenant une instruction pour qu'un véhicule de transport (V) saisisse un article (W) au niveau de l'orifice de saisie (V), se déplace d'un orifice de saisie (PF1) vers l'orifice de déchargement (PT1 ; PT2 ; PT3) le long de l'itinéraire de déplacement et décharge l'article (W) au niveau de l'orifice de déchargement (PT1 ; PT2 ; PT3), uniquement si l'itinéraire de déplacement du véhicule de transport (V) allant de l'orifice de saisie (PF) à l'orifice de déchargement (PT1 ; PT2 ; PT3) peut être assuré sur la voie (TA ; TA1) ;
l'attribution d'une première instruction de transport spéciale pour amener le véhicule de transport (V) à saisir un article (W) au niveau d'un orifice de saisie (PF1) et se déplacer vers un point spécifié (P1 ; P2 ; P3) sur le côté aval de l'orifice de saisie (PF1) dans une direction de déplacement du véhicule de transport (V) au niveau duquel un itinéraire de déplacement peut être assuré sur la voie (TA ; TA1), au lieu d'une instruction de transport normale, dans un cas où un itinéraire de déplacement du véhicule de transport (V) allant d'un orifice de saisie (PF1) à un orifice de déchargement (PT1 ; PT2 ; PT3) désigné par l'instruction de transport ne peut pas être assuré sur la voie (TA ; TA1) ; et
l'attribution d'une deuxième instruction de transport spéciale pour amener le véhicule de transport (V) à se déplacer du point spécifié (P1 ; P2 ; P3) à l'orifice de déchargement (PT1 ; PT2 ; PT3) et à décharger l'article au niveau de l'orifice de déchargement (PT1 ; PT2 ; PT3), dans un cas où un itinéraire de déplacement allant du point spécifié (P1 ; P2 ; P3) à l'orifice de déchargement (PT1 ; PT2 ; PT3) peut être assuré au moment où le véhicule de transport (V) s'approche ou atteint le point spécifié (P1 ; P2 ; P3) sur la base des informations de fermeture décrites ci-dessus.
